# EUROPEAN PATENT APPLICATION

(11) **EP 2 192 610 A2**
(43) Date of publication of application: **02.06.2010**
(21) Application number: 09176717.8
(22) Date of filing: 23.11.2009
(51) Int. Cl.: H01L 21/306

(54) **Processing method for uniformizing film thickness distribution of layer having predetermined film thickness formed on surface of silicon wafer and processing method for uniformizing thickness distribution of silicon wafer**

(30) Priority: 26.11.2008 JP 2008301258
(71) Applicant: SUMCO Corporation, Tokyo 105-8634 (JP)
(72) Inventor: Okita, Kenji, Tokyo 105-8634 (JP)
(74) Representative: Cabinet Plasseraud

(57) **Abstract**

In order to uniformize a film thickness distribution of a layer (e.g., an SOI layer) having predetermined film thickness formed on a surface of a silicon wafer, a processing method includes an oxidation step of forming a natural oxide film on a surface of the SOI layer and an etching step of removing, with etching liquid, the natural oxide film formed in a local thick film portion of the SOI layer while leaving a part (e.g., 1 Å to 2 Å) of the thickness. Since a main surface of the SOI layer is converted into the natural oxide film, the natural oxide film can be easily etched with hydrofluoric acid and etching processing can be locally performed. Therefore, the film thickness distribution of the SOI layer can be accurately uniformized by subjecting the thick film portion of the SOI layer to the etching processing.

## Description

### BACKGROUND OF THE INVENTION

### Field of the Invention

The present invention relates to a processing method for uniformizing a film thickness distribution of a layer (e.g., an SOI layer of an SOI wafer) having predetermined film thickness formed on the surface of a silicon wafer and a processing method for uniformizing a thickness distribution of a silicon wafer.

### Description of the Related Art

Layers having predetermined film thickness such as an SOI (Silicon On Insulator) layer, a surface silicon layer formed by DSB (Direct Silicon Bonding), an epitaxial layer, and a polysilicon layer are formed on the surface of a silicon wafer according to applications.

The SOI layer is formed on a main surface of a SIMOX wafer, in which a buried oxide layer (BOX: Buried OXide) is formed in the silicon wafer, by, for example, a SIMOX (Separation by IMplanted OXygen) method.

On the other hand, according to microminiaturization and a reduction in power consumption of devices, development of a DSB wafer formed by directly bonding two silicon wafers without the intervention of a BOX layer is also performed. The DSB wafer is formed by directly bonding a silicon wafer for active layer and a silicon wafer for support, which have different crystal orientations, after SC1-cleaning the same. The surface silicon layer is formed by performing grinding or the like from the surface of the silicon wafer for active layer.

Incidentally, the thickness of the SOI layer of the SIMOX wafer affects a manufacturing process for a semiconductor device and the like and a characteristic of the semiconductor device. Therefore, as described in, for example, JP2007-266059A, after an oxide film on the SOI layer is removed, the layer thickness of the SOI layer is measured and, when the layer thickness exceeds a predetermined layer thickness, the SOI layer is removed by etching to adjust the layer thickness.

### SUMMARY OF THE INVENTION

However, in the related art described in JP2007-266059A and the like, the SOI layer is only etched substantially uniformly or with a fixed distribution. Uniformity of the film thickness of the SOI layer is not taken into account.

Specifically, in the SIMOX wafer, in some case, a thick film portion in which the film thickness of the SOI layer is large and a thin film portion in which the film thickness is small occur because of, for example, variation in a treatment gas flow rate and a temperature distribution during heat treatment and the like. A non-uniform distribution of the thick film portion and the thin film portion having such film thicknesses is small (e.g., several angstroms to several tens angstroms). However, when a semiconductor device is formed by using the SIMOX wafer in which the film thickness of the SOI layer is non-uniform, there is a fear that a characteristic of the semiconductor device is adversely affected and yield falls. Therefore, it is desired to uniformize a film thickness distribution of the SOI layer.

As in the SOI layer, it is also desired to uniformize a film thickness distribution of the layers having the predetermined film thicknesses formed on the surface of the silicon wafer such as the surface silicon layer formed by the DSB, the epitaxial layer, and the polysilicon layer. Further, it is also desired to uniformize a thickness distribution of the silicon wafer itself.

A first problem to be solved by the present invention is to uniformize a film thickness distribution of a layer having predetermined film thickness formed on the surface of a silicon wafer. A second problem to be solved by the present invention is to uniformize a thickness distribution of the silicon wafer.

In order to solve the first problem, a first aspect of the present invention is a processing method for uniformizing a film thickness distribution of a layer having predetermined film thickness formed on the surface of a silicon wafer, the processing method characterized by including an oxidation step of forming a natural oxide film on the surface of the layer having the predetermined film thickness; and an etching step of removing, with etching liquid, the natural oxide film formed in a local thick film portion of the layer having the predetermined film thickness while leaving a part of the thickness.

Here, the layer having the predetermined film thickness formed on the surface of the silicon wafer is any one of an SOI layer on a main surface of an SOI wafer in which a buried oxide layer is formed, a surface silicon layer formed by the DSB, an epitaxial layer, and a polysilicon layer.

Taking the SOI layer on the main surface of the SOI wafer as an example, since, in general, the main surface of the SOI layer is covered with a natural oxide film, it is conceivable to locally etch a thick film portion of the SOI layer to uniformize a film thickness distribution using etching liquid (e.g., a mixed solution of hydrofluoric acid (HF) and ozone water) that can etch the natural oxide film and the SOI layer in a continuous process.

However, when the natural oxide film is removed, the SOI surface is exposed and tends to absorb foreign matters such as particles because the exposed SOI surface has water repellency. If the absorbed particles cannot be fully removed in a cleaning step after that, a characteristic of a semiconductor device is affected.

Therefore, the present invention has been devised in view of the fact that the thickness of the natural oxide film formed on the surface of the SOI layer depends upon a diffusion characteristic of oxygen diffusing in the SOI layer and is fixed thickness irrespective of a film thickness distribution of the SOI layer. Specifically, it is possible to reduce the thickness of the thick film portion and uniformize the film thickness of the SOI layer by locally removing, with the etching liquid, only the natural oxide film of the SOI layer formed in the thick film portion of the SOI layer. In this case, it is essential to remove, with the etching liquid, the natural oxide film formed on the main surface of the SOI layer while leaving a part (e.g., 1 Å to 2 Å) of the thickness of the natural oxide film. Consequently, since the SOI surface is not exposed, it is possible to prevent the particles of the foreign matters from adhering to the SOI surface.

In this case, it is preferable to set an upper limit for the thickness of the natural oxide film to be removed by one etching and prevent the SOI surface from being exposed. In this case, it is desirable to repeatedly perform the oxidation step and the etching step according to the thickness of the thick film portion of the SOI layer.

The natural oxide film can be formed by applying the ozone water to the main surface of the SOI layer. In this case, it is preferable to clean residual ozone components on the main surface with pure water after forming the natural oxide film. Further, it is desirable to use hydrofluoric acid as the etching liquid. Specifically, since the SOI layer cannot be etched by the hydrofluoric acid, the natural oxide film is once formed on the main surface of the SOI layer of the thick film portion and only the portion of the natural oxide film of the thick film portion is etched to uniformize the film thickness of the SOI layer.

Further, a second aspect of the processing method for uniformizing a film thickness distribution of a layer having predetermined film thickness formed on the surface of a silicon wafer according to the present invention is characterized by including: a measuring step of measuring a film thickness distribution of the layer having the predetermined film thickness formed on the surface of the silicon wafer; a film thickness adjustment region setting step of setting, on the basis of the film thickness distribution of the layer having the predetermined film thickness measured by the measuring step, a thick film portion that should be etched; a target etching amount setting step of setting a target etching amount of a set film thickness adjustment region; an oxidation step of forming a natural oxide film on the surface of the layer having the predetermined film thickness; and an etching step of removing, with etching liquid, the natural oxide film formed in the thick film portion that should be etched while leaving a part of the thickness of the natural oxide film.

In this case, as in the case explained above, the layer having the predetermined film thickness formed on the surface of the silicon wafer is any one of an SOI layer on a main surface of an SOI wafer in which a buried oxide layer is formed, a surface silicon layer formed by the DSB, an epitaxial layer, and a polysilicon layer.

Taking the SOI layer on the main surface of the SOI wafer as an example, a film thickness distribution of the SOI layer on the main surface of the SOI wafer is measured and a film thickness adjustment region of the thick film portion that should be removed by etching is set on the basis of the measured film thickness distribution of the SOI layer. This film thickness adjustment region can be set in plural places according to the film thickness distribution. It is preferable to set a center point of the film thickness adjustment region taking into account the spread of the etching liquid on the main surface of the SOI layer. A target etching amount of the set film thickness adjustment region is set. As this target etching amount, a target etching amount is set on the basis of a measurement value of the film thickness distribution and according to the thicknesses of thick film portions of respective film thickness adjustment regions with reference to the thinnest film portion. After the natural oxide film is formed on the main surface of the entire wafer, the natural oxide film formed in the thick film portions of the respective film thickness adjustment regions is removed by the etching liquid with a part of the thickness of the natural oxide film left.

In this case, it is preferable to set an upper limit for the thickness of the natural oxide film to be removed by one etching for center points of the respective film thickness adjustment regions and prevent the SOI surface from being exposed. In this case, it is desirable to repeatedly perform the oxidation step and the etching step dividedly plural times according to the thicknesses of the thick film portions of the SOI layer in the respective film thickness adjustment regions.

In the first and second aspects of the present invention, the oxidation step can include a step of applying ozone water to the main surface to form the natural oxide film and a step of cleaning, with pure water, residual ozone components on the main surface after this step. In the etching step, it is possible to use an etching nozzle including an etching liquid nozzle that causes any one of solutions of hydrofluoric acid, buffered hydrofluoric acid, and fluoric ammonium to flow out as the etching liquid and plural pure water nozzles that are arranged to surround this etching liquid nozzle and cause the pure water to flow out. In this case, it is possible to cause the etching liquid corresponding to an etching amount of the respective film thickness adjustment regions to flow out from the etching liquid nozzle and cause the pure water to continuously flow out from the plural pure water nozzles to perform the etching step.

In this case, it is preferable to perform, while rotating the SOI wafer, the step of forming the natural oxide film and the step of cleaning (rinsing) the residual ozone components with the pure water. Note that the etching step is performed with the etching nozzle moved to and positioned in the center points of the respective film thickness adjustment regions in a state in which the SOI wafer is fixed.

With the etching nozzle according to the present invention, since the plural pure water nozzles are circularly arranged to surround the etching liquid nozzle, it is possible to suppress the spread of the etching liquid with the pure water and limit an etching region. Note that an etching amount has fixed spread from the center of the etching liquid nozzle and a distribution occurs in which the etching amount decreases farther away from the center. Therefore, it is preferable to set the center points of the respective film thickness adjustment regions taking into account the distribution of the etching amount.

In order to solve the second problem, a processing method for uniformizing a thickness distribution of a silicon wafer of the present invention is characterized by including: an oxidation step of forming a natural oxide film on a main surface of the silicon wafer; and an etching step of removing, with etching liquid, the natural oxide film formed in a locally thick portion of the silicon wafer while leaving a part of the thickness of the natural oxide film. With this processing method, according to a principle the same as a principle for uniformizing a film thickness distribution of a layer having predetermined film thickness formed on the surface of the silicon wafer, it is possible to uniformize the thickness distribution of the silicon wafer.

### BRIEF DESCRIPTION OF THE DRAWINGS

FIG. 1 is a diagram showing a procedure in an embodiment of uniformizing processing for the film thickness of an SOI layer as a main surface of an SOI wafer;
FIG. 2 is a diagram showing a setting procedure in the embodiment of the uniformizing processing for the film thickness of the SOI layer as the main surface of the SOI wafer;
FIG. 3 is a diagram showing a schematic diagram of a uniformizing processing apparatus for explaining operation in the embodiment;
FIG. 4 is a diagram showing a schematic diagram of an etching nozzle of the embodiment;
FIG. 5 is a diagram showing a graph of a relation between the concentration of hydrofluoric acid and an etching rate of a natural oxide film; and
FIG. 6 is a diagram showing an example of a relation among hydrofluoric acid concentration, an etching rate, and processing time.

### DETAILED DESCRIPTION OF THE INVENTION

A processing method for uniformizing a film thickness distribution of a layer having predetermined film thickness formed on the surface of a silicon wafer according to the present invention is explained below on the basis of an embodiment. This embodiment is explained with reference to an SOI layer on an SOI wafer main surface as an example of the layer having the predetermined film thickness formed on the surface of the silicon wafer.

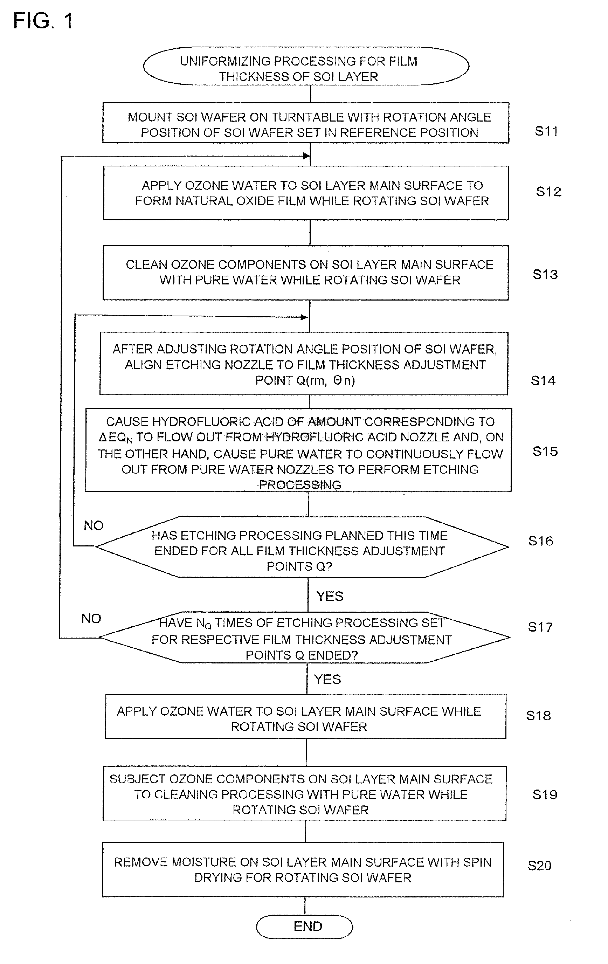

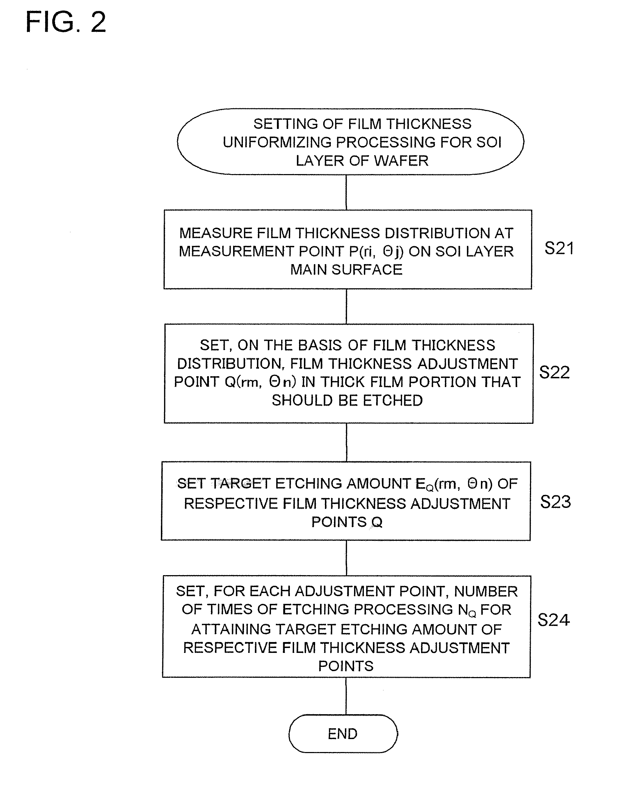

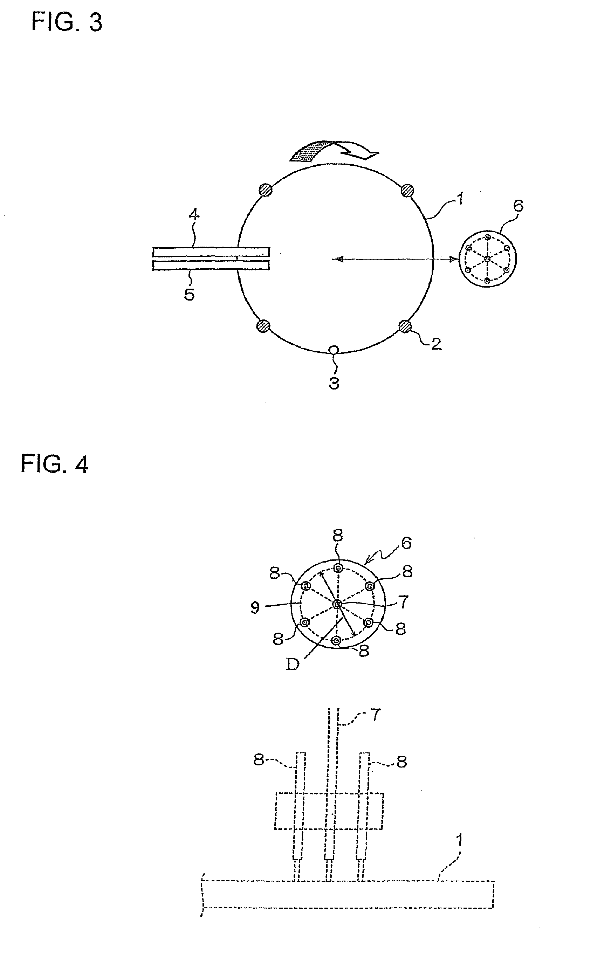

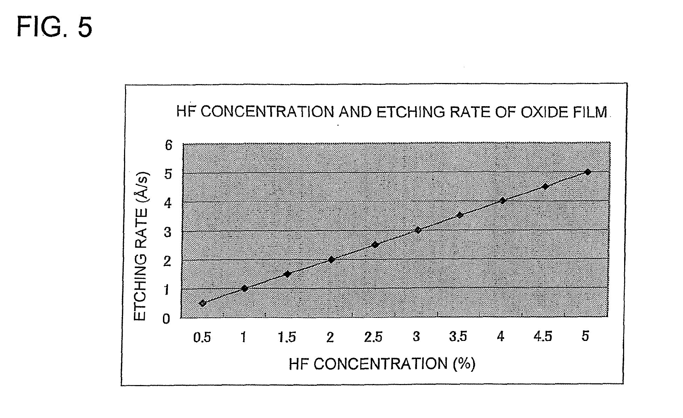

A procedure in an embodiment of the processing method for uniformizing a film thickness distribution of an SOI layer as an SOI wafer main surface is shown in FIG. 1. A setting procedure in the embodiment of uniformizing processing for a film thickness distribution of an SOI layer is shown in FIG. 2. A schematic diagram of a uniformizing processing apparatus for explaining operation in the embodiment is shown in FIG. 3. A schematic diagram of an etching nozzle in the embodiment is shown in FIG. 4. A graph of a relation between the concentration of hydrofluoric acid and an etching rate of an oxide film is shown in FIG. 5.

First, the setting procedure of the uniformizing processing for a film thickness distribution of an SOI layer of an SOI wafer is explained with reference to FIG. 2.

### (Step S21)

A film thickness distribution of a main surface of the SOI layer is measured. In this measurement, plural measurement points P(ri, θj) are set on a main surface of a circular SOI wafer according to, for example, a polar coordinate system (r, θ). Here, ri is a radius position. θj is a rotation angle (0π to 2π) from a reference position (e.g., a notch) of the SOI wafer. i and j are natural numbers. Film thicknesses at the respective measurement points P(ri, θj) can be measured by using, for example, an optical measuring device that analyzes interference of reflection of light and measures film thickness. However, the measurement of film thicknesses is not limited to this.

### (Step S22)

A center point Q(rm, θn) of a film thickness adjustment region is set in a thick film portion, which should be removed by etching, on the basis of the film thickness distribution of the SOI layer measured in step S21. A plurality of the center points Q of the film thickness adjustment region can be set according to the film thickness distribution. As explained later, the center point Q of the film thickness adjustment region is set with the spread of etching liquid flowing out to the main surface of the SOI layer taken into account.

### (Step S23)

A target etching amount E_{Q}(rm, θn) is set concerning the center points Q of the respective film thickness adjustment regions set in step S22. This target etching amount E_{Q} is set on the basis of a measurement value of the film thickness distribution and according to the thickness of thick film portions of the respective film thickness adjustment regions with reference to the thinnest film portion.

### (Step S24)

A number of times of etching processing N (a natural number) that attains the target etching amount E_{Q} of the center points Q of the respective film thickness adjustment regions set in step S23 is set. Specifically, the thickness of the natural oxide film formed on the main surface of the SOI layer by causing ozone water to flow out depends upon a diffusion characteristic of oxygen to the SOI layer and depends upon processing time by the ozone water. On the other hand, in order to manage the SOI layer not to be exposed and prevent particles of impurities from adhering to the SOI layer, it is necessary to etch the natural oxide film while leaving a part (e.g., 1 Å to 2 Å) of the thickness of the natural oxide film.

Therefore, if an upper limit value (e.g., 6 Å) is set for the thickness of the natural oxide film to be removed by one etching, in the case of a thick film portion having thickness exceeding the upper limit value, the target etching amount E_{Q} cannot be attained by one etching. Therefore, the number of times of etching processing N necessary for attaining the target etching amount E_{Q} is set.

In this way, in steps S21 to S24, a film thickness distribution on the SOI layer main surface is measured for each one SOI wafer and the target etching amount E_{Q} of the center point Q of the film thickness adjustment region set on the basis of the thick film portion requiring thickness adjustment and the number of times of etching processing N (a natural number) necessary for attaining the target etching amount E_{Q} are set.

Next, the film thickness of the SOI layer of the SOI wafer is subjected to uniformizing processing according to the procedure shown in FIG. 1 on the basis of the center points Q of the respective film thickness adjustment regions set for each one SOI wafer, the target etching amount E_{Q} of the center points of the respective film thickness adjustment regions set, and the number of times of etching processing N_{Q} set for each of the film thickness adjustment regions in steps S21 to S24 in FIG. 2.

The uniformizing processing for the SOI layer film thickness of the SOI wafer main surface can be executed by using, for example, the uniformizing processing apparatus shown in the schematic diagram in FIG. 3. Specifically, as shown in the figure, each SOI wafer 1 as a processing target is fixed on an upper surface of a not-shown turntable by plural (in the example shown in the figure, four) clamps 2. The turntable controllably holds a rotation angle with a spin chuck having high corrosion resistance. In the SOI wafer 1, a notch 3 indicating a reference position is fixed according to the position of the turntable set in advance.

An ozone water nozzle 4 and a pure water nozzle 5 are arranged above a main surface of the SOI wafer 1. An etching nozzle 6 is arranged above the main surface of the SOI wafer 1 and held to be movable in a radial direction of the main surface of the SOI wafer 1. The etching nozzle 6 is configured by arranging, for example, as shown in FIG. 4, one hydrofluoric acid nozzle 7 that causes hydrofluoric acid to flow out and plural (in the example shown in the figure, six) pure water nozzles 8 along a circle around the hydrofluoric acid nozzle 7. A diameter D of a circle 9 in which the pure water nozzles 8 are arranged can be set to about 25 mm to 50 mm.

Note that a diameter D of the etching nozzle 6 can be set as appropriate with target accuracy and processing time of film thickness uniformity taken into account. Specifically, since the size of the diameter D corresponds to the size of an area to be etched with hydrofluoric acid, when target accuracy of planarization is set high, it is desirable to set the size of the diameter D small. However, since the number of center points of the film thickness adjustment regions increases, the processing time increases.

Next, a procedure in the embodiment for executing the film thickness uniformizing processing for the SOI layer of the SOI wafer main surface using the uniformizing processing apparatus shown in the schematic diagram in FIG. 3 is explained with reference to FIG. 1.

### (Step S11)

First, the SOI wafer 1 is mounted on the turntable with the position (a rotation angle position) of the notch 3 of the SOI wafer 1 set in the reference position.

### (Step S12)

The ozone water is caused to flow out to the main surface of the SOI layer from the ozone water nozzle 4 while the turntable is rotated to rotate the SOI wafer 1. Consequently, the ozone water is applied to the main surface of the SOI layer, oxygen ion in the ozone water diffuses to the inside of the SOI layer, and a natural oxide film having uniform thickness is formed over the entire main surface. The thickness of the natural oxide film can be managed according to, for example, application time of the ozone water.

### (Step S13)

After the natural oxide film having predetermined thickness (e.g., 6 Å) is formed in step S12, ozone components on the main surface of the SOI layer are cleaned (rinsed) by the pure water to stop the oxidation while the SOI wafer 1 is rotated.

### (Step S14)

Subsequently, after the rotation of the SOI wafer 1 is stopped and the rotation angle position of the SOI wafer 1 is adjusted, the etching nozzle 6 is aligned with the center point Q (rm, θn) of the film thickness adjustment region. At this point, for example, the position of the etching nozzle 6 is moved to a circumferential edge of the SOI wafer 1. An angle position of the SOI wafer 1 is set such that the center point Q(rm, θn) of the film thickness adjustment region is set in an angle position in a moving direction of the etching nozzle 6. Subsequently, the etching nozzle 6 is moved in the radial direction toward the center of the SOI wafer 1 and stopped at the center point Q(rm, θn) of predetermined film thickness adjustment region.

### (Step S15)

hydrofluoric acid of an amount corresponding to a target etching amount ΔE_{Q (N=1)}, which is a machining allowance for the natural oxide film for the first time, is caused to flow out from the hydrofluoric acid nozzle 7 to the center point Q(rm, θn) of the film thickness adjustment region controlled in step S14 to execute etching processing. While the etching processing is executed, the pure water can be caused to continuously flow out from the pure water nozzles 8. However, it is desirable to cause the pure water to flow out at least before the hydrofluoric acid is caused to flow out from the hydrofluoric acid nozzle 7 and stop the pure water after the flow-out of the hydrofluoric acid is ended. At this point, the pure water is caused to continuously flow out from the pure water nozzles 8 to prevent the hydrofluoric acid from spreading from the set center point Q(rm, θn) of the film thickness adjustment region. In other words, since the hydrofluoric acid caused to flow out from the center of the hydrofluoric acid nozzle 7 spreads to a fixed range, the etching is prevented from spreading to regions other than the center point of the film thickness adjustment region. Since a distribution occurs in which an etching amount decreases farther away from the center of the hydrofluoric acid nozzle 7, in step S22 in FIG. 2, the center point of the film thickness adjustment region is set with the distribution of the etching amount taken into account.

### (Step S16)

In this step, it is determined whether the etching processing ends for all film thickness adjustment regions planned to be etched this time (e.g., N=1, 2, ...). If there is a film thickness adjustment region for which the etching processing does not end, the procedure returns to step S14 and is repeated. At this point, all hydrofluoric acid components on the surface of the SOI wafer 1 are removed by the pure water while the SOI wafer 1 is rotated. The procedure returns to step S14.

### (Step S17)

Subsequently, it is determined whether N_{Q} times of etching processing set for each of the center points Q of the respective film thickness adjustment regions ends. If there is a film thickness adjustment region where the etching processing has not reached N_{Q} times yet, the procedure returns to S12 and is repeated. When the etching processing set for all the film thickness adjustment regions ends N_{Q} times, the procedure shifts to step S18.

### (Step S18)

The ozone water is caused to flow out from the ozone water nozzle 4 to the SOI layer main surface of the SOI wafer 1 while the SOI wafer 1 is rotated. Consequently, a natural oxide film having uniform thickness is formed over the entire main surface of the SOI wafer 1.

### (Step S19)

Further, the pure water is caused to flow out from the pure water nozzle 5 to the SOI layer main surface of the SOI wafer 1 to clean (rinse) ozone components on the main surface while the SOI wafer 1 is rotated.

### (Step S20)

Subsequently, moisture is removed by spin drying for rotating the SOI wafer 1 and the film thickness uniformizing processing for the SOI layer on the main surface of the one SOI wafer 1 is ended.

### [Example]

Here, a condition of a specific example in the planarization processing for the SOI wafer main surface is explained. First, the ozone concentration of the ozone water used for the generation of the natural oxide film can be set to 200 ppm. However, the ozone concentration is selected in a range of 5 ppm to 100 ppm. The concentration of the hydrofluoric acid can be set to 1%. However, the concentration is selected in a range of 0.25% to 5%. The number of measurement points of an irregularity distribution on the main surface can be set to fifty-seven in, for example, an SOI wafer having a 300 mm diameter. However, the number of measurement points only has to be set according to a relation with target accuracy of planarization.

A procedure of the planarization processing can be established by forming an irregularity pattern at, for example, a 3Å unit and setting the number of times of etching processing N to, for example, "3" on the basis of an initial irregularity distribution on the main surface of the SOI wafer. In particular, as shown in FIG. 5, an etching amount of the natural oxide film by hydrofluoric acid (HF) is related to an etching rate (Å/second) that depends upon the concentration (%) and the temperature of the hydrofluoric acid. Therefore, the concentration (%) and an amount (flow-out time) of the hydrofluoric acid caused to flow out from the hydrofluoric acid nozzle 7 are controlled according to a target etching amount per one time. Note that, in FIG. 5, the temperature of the hydrofluoric acid is 20°C to 30°C.

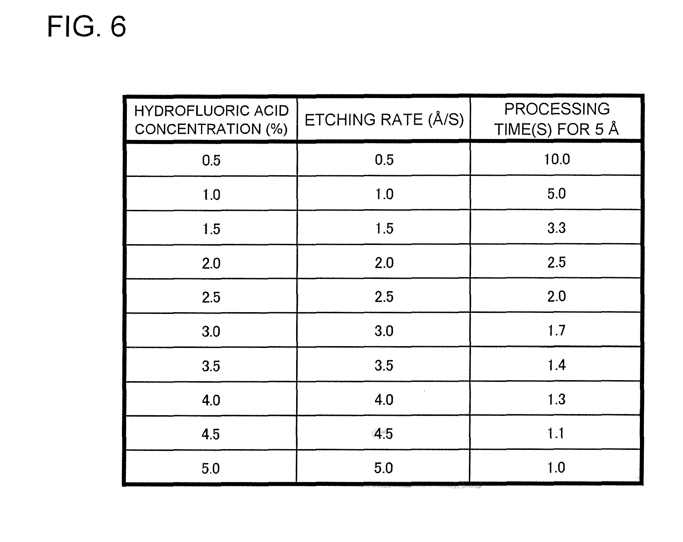

A graph of a relation between the concentration of the hydrofluoric acid and the etching rate of the natural oxide film is shown in FIG. 6. In FIG. 6, a first column represents the concentration (%) of the hydrofluoric acid, a second column represents the etching rate (Å/s) of the oxide film, and a third column represents processing time in etching the oxide film by 5 Å. An etching amount can be managed according to time on the basis of these hydrofluoric acid concentrations (%) and etching processing time.

As explained above, according to this embodiment, the ozone water is applied to the main surface of the SOI layer and converted into the natural oxide film. Therefore, the natural oxide film can be easily etched with the hydrofluoric acid and the etching processing can be locally performed. Therefore, a film thickness distribution of the SOI layer can be accurately uniformized by repeating these kinds of processing to subject the thick film portion of the SOI layer to the etching processing.

The natural oxide film of the SOI layer is etched with the hydrofluoric acid such that the SOI surface is not exposed with a part (e.g., 1 to 2 Å) of the thickness of the natural oxide film of the SOI layer left, i.e., with the upper limit set for the thickness of the natural oxide film to be removed by one etching. Therefore, particles of foreign matters can be prevented from adhering to the SOI surface and yield and the like of the semiconductor device can be improved.

The hydrofluoric acid caused to flow out from the hydrofluoric acid nozzle 7 is prevented from spreading from the film thickness adjustment region by causing the pure water to continuously flow out from the pure water nozzles 8. Therefore, since an area to be etched for film thickness adjustment can be accurately controlled, uniformity of film thickness can be accurately adjusted.

In this embodiment, the example in which the hydrofluoric acid is used as the solution for etching the natural oxide film is explained. However, the present invention is not limited to this. Solutions of buffered hydrofluoric acid and fluoric ammonium can be used as the solution for etching the natural oxide film.

In this embodiment, uniformizing of the film thickness distribution of the SOI layer on the SOI wafer main surface is explained as the example. However, the present invention is not limited to this. A film thickness distribution of any one of a surface silicon layer formed by the DSB, an epitaxial layer, and a polysilicon layer can also be uniformized. Specifically, an SOI layer and layers having predetermined film thickness such as a surface silicon layer formed by the DSB, an epitaxial layer, and a polysilicon layer are formed on the surface of a silicon wafer according to applications. In all of these layers having the predetermined film thickness, a film thickness distribution can be uniformized according to a principle the same as a principle for uniformizing the film thickness distribution of the SOI layer explained above.

The present invention can be applied not only to a case in which a film thickness distribution of a layer having predetermined film thickness formed on the surface of a silicon wafer is uniformized but also to a case in which a thickness distribution of the silicon wafer itself is uniformized. Specifically, like the thickness of the natural oxide film formed on the surface of the SOI layer, the thickness of a natural oxide film formed on the surface of the silicon wafer depends upon a diffusion characteristic of oxygen diffusing to the silicon wafer and is fixed thickness irrespective of the thickness distribution of the silicon wafer. Therefore, the thickness distribution of the silicon wafer can be uniformized according to the principle same as the principle for uniformizing of the film thickness distribution of the SOI layer.

More specifically, the processing method for uniformizing a thickness distribution of a silicon wafer is configured by including an oxidation step of forming a natural oxide film on a main surface of the silicon wafer and an etching step of removing, with etching liquid, the natural oxide film formed in a locally thick portion of the silicon wafer while leaving a part of the thickness of the natural oxide film. The oxidation step and the etching step are repeatedly performed according to the thickness of the locally thick portion of the silicon wafer.

## Claims

1. A processing method for uniformizing a film thickness distribution of a layer having predetermined film thickness formed on a surface of a silicon wafer, the processing method comprising:
an oxidation step of forming a natural oxide film on a surface of the layer having the predetermined film thickness; and
an etching step of removing, with etching liquid, the natural oxide film formed in a local thick film portion of the layer having the predetermined film thickness while leaving a part of the thickness.

2. The processing method for uniformizing a film thickness distribution of a layer having predetermined film thickness formed on a surface of a silicon wafer according to claim 1, wherein the layer having the predetermined film thickness is any one of an SOI layer on a main surface of an SOI wafer in which a buried oxide layer is formed, a surface silicon layer formed by DSB, an epitaxial layer, and a polysilicon layer.

3. The processing method for uniformizing a film thickness distribution of a layer having predetermined film thickness formed on a surface of a silicon wafer according to claim 1, wherein
the etching step includes setting an upper limit for the thickness of the natural oxide film to be removed by one etching, and
the oxidation step and the etching step are repeatedly performed according to the thickness of the thick film portion of the layer having the predetermined film thickness.

4. A processing method for uniformizing a film thickness distribution of a layer having predetermined film thickness formed on a surface of a silicon wafer, the processing method comprising:
a measuring step of measuring a film thickness distribution of the layer having the predetermined film thickness formed on the surface of the silicon wafer;
a film thickness adjustment region setting step of setting, on the basis of the film thickness distribution of the layer having the predetermined film thickness measured by the measuring step, a thick film portion that should be etched;
a target etching amount setting step of setting a target etching amount of the set film thickness adjustment region;
an oxidation step of forming a natural oxide film on a surface of the layer having the predetermined film thickness; and
an etching step of removing, with etching liquid, the natural oxide film formed in the thick film portion that should be etched while leaving a part of the thickness of the natural oxide film.

5. The processing method for uniformizing a film thickness distribution of a layer having predetermined film thickness formed on a surface of a silicon wafer according to claim 4, wherein the layer having the predetermined film thickness is any one of an SOI layer on a main surface of an SOI wafer in which a buried oxide layer is formed, a surface silicon layer formed by DSB, an epitaxial layer, and a polysilicon layer.

6. The processing method for uniformizing a film thickness distribution of a layer having predetermined film thickness formed on a surface of a silicon wafer according to claim 4, wherein
the etching step includes setting an upper limit for the thickness of the natural oxide film to be removed by one etching, and
the oxidation step and the etching step are repeatedly performed according to the thickness of the thick film portion of the layer having the predetermined film thickness.

7. The processing method for uniformizing a film thickness distribution of a layer having predetermined film thickness formed on a surface of a silicon wafer according to claim 4, wherein
the oxidation step includes a step of applying ozone water to the surface of the layer having the predetermined film thickness to form the natural oxide film and a step of cleaning, with pure water, residual ozone components on the surface of the layer having the predetermined film thickness after the step, and
the etching step is performed by using an etching nozzle including an etching liquid nozzle that causes any one of solutions of hydrofluoric acid, buffered hydrofluoric acid, and fluoric ammonium to flow out as the etching liquid and plural pure water nozzles that are arranged to surround the etching liquid nozzle and cause the pure water to flow out, causing the etching liquid corresponding to an etching amount of the film thickness adjustment regions to flow out from the etching liquid nozzle, and causing the pure water to continuously flow out from the plural pure water nozzles.

8. The processing method for uniformizing a film thickness distribution of a layer having predetermined film thickness formed on a surface of a silicon wafer according to claim 7, wherein
the step of forming the natural oxide film and the step of cleaning the residual ozone components with the pure water are performed while the silicon wafer is rotated, and
the etching step is performed with the etching nozzle moved to and positioned in center points of the film thickness adjustment regions in a state in which the silicon wafer is fixed.

9. A processing method for uniformizing a thickness distribution of a silicon wafer, the processing method comprising:
an oxidation step of forming a natural oxide film on a main surface of the silicon wafer; and
an etching step of removing, with etching liquid, the natural oxide film formed in a locally thick portion of the silicon wafer while leaving a part of the thickness of the natural oxide film.
